# FASCICULE DE BREVET EUROPEEN

(11) **EP 0 562 982 B1**
(45) Date de publication et mention de la délivrance du brevet: **12.02.1997**
(21) Numéro de dépôt: 93420128.6
(22) Date de dépôt: 23.03.1993
(51) Int. Cl.: H01L 27/10, H01L 29/861, H02H 9/04, H02H 7/20

(54) **Circuit intégré constituant un réseau de diodes de protection**
Schutzdiodennetz bildende integrierte Schaltung
Integrated circuit comprising a network of protection diodes

(30) Priorité: 26.03.1992 FR 9204130
(43) Date de publication de la demande: 29.09.1993
(73) Titulaire: SGS-THOMSON MICROELECTRONICS S.A., 94250 Gentilly (FR)
(72) Inventeur: Bernier, Eric, F-37000 Tours (FR)
(74) Mandataire: de Beaumont, Michel

(56) Documents cités:
- EP-A- 0 318 404
- PATENT ABSTRACTS OF JAPAN vol. 12, no. 24 (E-576)23 Janvier 1988 & JP-A-62 179 756

## Description

La présente invention concerne les circuits de protection et plus particulièrement les réseaux de diodes utilisés pour la protection de systèmes informatiques.

Dans les systèmes informatiques, on trouve souvent des connecteurs auxquels sont reliés un grand nombre de lignes dont le potentiel est susceptible de varier entre des premier et deuxième états correspondant à des première et deuxième tensions.

On considérera ci-après plus particulièrement le cas où la première tension est la masse et où la deuxième tension est une tension positive, par exemple +5 volts. Mais il sera clair que plus généralement les tensions de ces lignes peuvent varier entre une tension haute et une tension basse ou tension de référence.

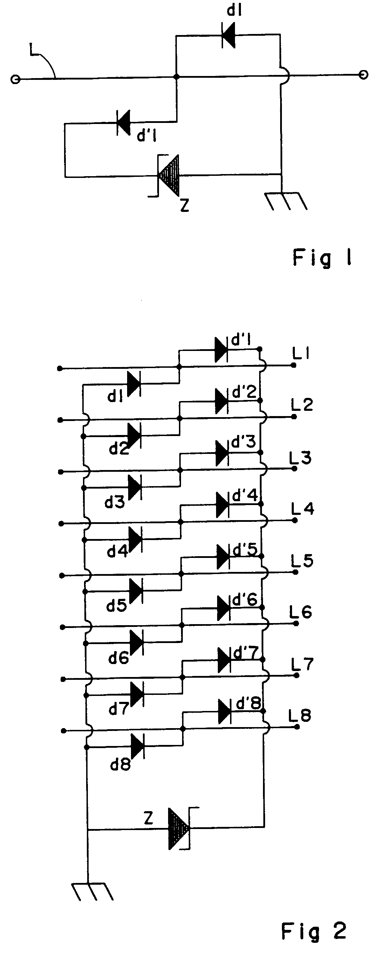

Un schéma de protection classique pour une ligne de ce type est illustré en figure 1. La ligne L est reliée à la tension de référence (la masse) par l'intermédiaire d'une diode (d1) polarisée en inverse et est également reliée à la masse par l'intermédiaire d'une diode polarisée en direct (d'1) en série avec une diode à avalanche (Z) polarisée en inverse dont la tension de seuil est voisine (légèrement supérieure) de la tension haute sur la ligne. Ainsi, une surtension négative sur la ligne L s'écoule vers la masse par la diode dl et une surtension positive, de valeur supérieure à la tension nominale de la ligne, s'écoule par la diode d'1 à travers la diode à avalanche Z.

En fait, dans les montages informatiques, on trouve un très grand nombre de lignes sur un connecteur et on est amené à leur associer de nombreux montages de protection du type de celui de la figure 1 présentant tous une même diode à avalanche en commun. Un tel montage est illustré en figure 2 où l'on trouve, en association avec chaque ligne L1 à L8, une diode dl à d8 connectée en inverse vers la masse et une diode d'1 à d'8 connectée en direct par une diode à avalanche Z vers la masse.

En pratique, on s'est aperçu qu'il était préférable de choisir pour les diodes dl à d8 et d'1 à d'8 des diodes de type Schottky pour réduire autant que possible les capacités entre ligne et masse et donc minimiser les phénomènes de diaphonie qui pourraient exister entre deux ou plusieurs lignes. De plus, de telles petites diodes Schottky présentent une relativement faible chute de tension en direct, peu supérieure à celle d'une diode à jonction classique.

Actuellement, ce type de montage est réalisé en utilisant des éléments discrets. Ceci entraîne un encombrement important et une main d'oeuvre coûteuse pour réaliser les diverses soudures nécessaires à la réalisation du montage. Ce sont là des inconvénients classiques de montages discrets par rapport à un montage intégré. Il faut souligner un inconvénient supplémentaire à savoir que les petites diodes schottky sont des composants fragiles, très sensibles à des surtensions en inverse qui sont susceptibles de les détruire. Le montage doit donc être accompagné de précautions importantes et reste toujours dangereux pour les composants élémentaires.

Un circuit de protection utilisant deux puces monolithiques montées en parallèle et dont les types de conductivité sont inversés est décrit dans EP-A-0 318 404.

Ainsi, la présente invention a pour objet de réaliser un réseau de diodes du type de celui de la figure 2 sous forme intégrée.

Pour atteindre cet objet, la présente invention prévoit un circuit intégré constituant un réseau de diodes comportant des premières diodes Schottky dont chacune est connectée par sa cathode à un point à protéger et par son anode à une tension de référence et des deuxièmes diodes Schottky dont chacune est connectée par son anode à un point à protéger et par sa cathode à la cathode d'une diode à avalanche dont l'anode est à la tension de référence. Ce circuit intégré comprend un substrat de type P faiblement dopé dont la face inférieure est fortement dopée ; un premier et un deuxième groupes de caissons de type N faiblement dopés formés dans la face supérieure du substrat ; un contact ohmique et un contact Schottky sur chaque caisson ; une région de type N fortement dopée sur la surface supérieure du substrat ; une première métallisation reliant les contacts ohmiques du premier groupe de caissons à la région de type N fortement dopée ; une deuxième métallisation reliant les contacts Schottky du deuxième groupe de caissons ; des troisièmes métallisations reliant respectivement un contact Schottky du deuxième groupe de caissons à un contact ohmique du premier groupe de caissons ; et une quatrième métallisation de face arrière.

Selon un mode de réalisation de la présente invention, en utilisation, la face arrière et la deuxième métallisation sont reliées à un potentiel de référence, et chacune des troisièmes métallisations est reliée à une ligne à protéger.

Selon un mode de réalisation de la présente invention, les premiers caissons forment un seul et même caisson.

Selon un mode de réalisation de la présente invention, la liaison entre la deuxième métallisation et le potentiel de référence est réalisée par un contact entre cette deuxième métallisation et une région surdopée de la face supérieure du substrat.

L'utilisation d'un circuit intégré selon la présente invention présente par rapport à l'utilisation d'un montage discret selon l'art antérieur les avantages habituels de réduction de coût, de faible encombrement, et de simplicité de montage. En outre, les diodes Schottky étant préassemblées avec une diode à avalanche, elles ne risquent plus d'être détruites par des surtensions lors de leur manipulation et de leur connexion aux lignes à protéger.

Ces objets, caractéristiques et avantages ainsi que d'autres de la présente invention seront exposés en détail dans la description suivante de modes de réalisation particuliers faite en relation avec les figures jointes parmi lesquelles :
les figures 1 et 2, décrites précédemment, sont des schémas de circuits de protection selon l'art antérieur ; et
les figures 3A et 3B sont respectivement une vue en coupe et une vue de dessus schématique d'un circuit intégré selon la présente invention, la figure 3A étant une coupe selon la ligne A-A de la figure 3B.

Dans ces diverses figures, comme cela est usuel dans le domaine de la représentation des circuits intégrés, les divers éléments ne sont pas représentés à l'échelle ni à l'intérieur d'une figure ni d'une figure à l'autre. D'autre part, les formes des diverses régions et caissons sont représentées de façon schématique avec des coins carrés. Il sera clair pour l'homme de l'art qu'en pratique ces coins sont arrondis par suite des diverses étapes de diffusion.

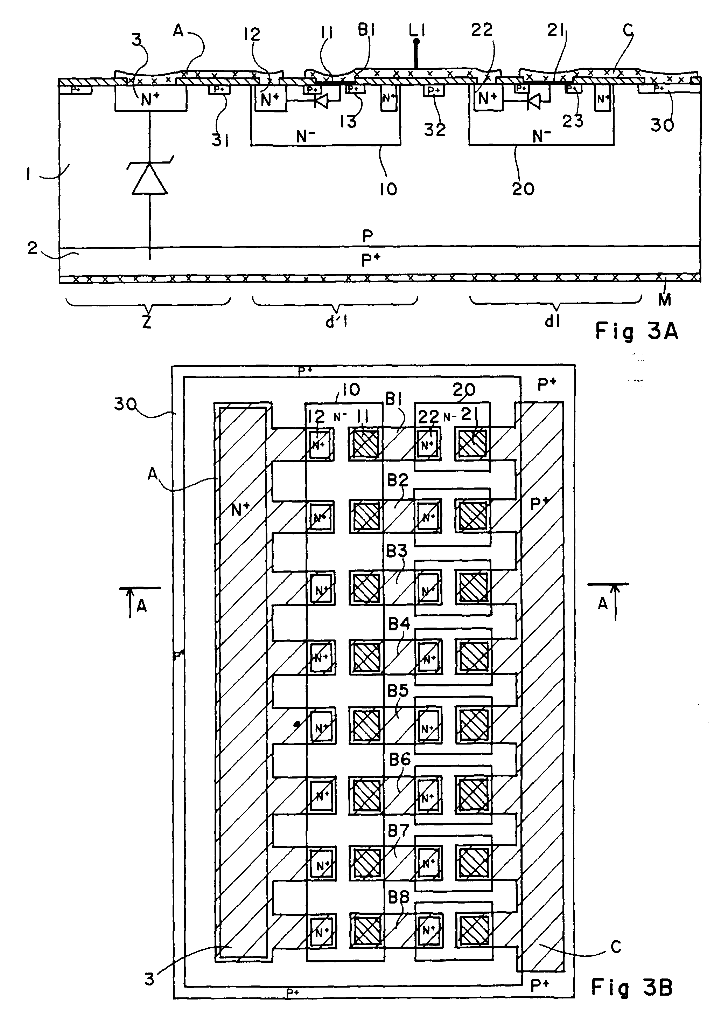

La figure 3A représente un circuit intégré formé à partir d'un substrat 1 de type P dont la face inférieure est munie d'une couche surdopée 2 (en pratique, la couche 2 peut être formée par surdopage à partir d'un substrat P ou inversement la région 1 de type P peut être formée par épitaxie sur un substrat de type P⁺ qui sera alors plus épais que cette couche).

La vue en coupe de la figure 3A illustre de gauche à droite une diode à avalanche Z, une diode d'1 et une diode d1 conformes au schéma de la figure 1.

La diode à avalanche Z est de type vertical et est formée entre une région 3 de type N fortement dopée et le substrat 1.

Les diodes d'1 et d1 sont formées dans des caissons de type N faiblement dopés 10 et 20 sur la surface supérieure desquels sont déposés des métallisations 11 et 21 formant avec ces caissons des barrières de Schottky. Des régions surdopées 12 et 22 permettent de prendre des contacts ohmiques avec les caissons 10 et 20.

Une première métallisation A établit une liaison entre les régions 3 et 12 et correspond à la liaison entre la cathode de la diode d'1 et la cathode de la diode à avalanche Z.

Une deuxième métallisation B1 établit un contact entre la région 22 et la métallisation 11 et correspond à la liaison entre l'anode de la diode d'1 et la cathode de la diode d1. C'est cette métallisation qui doit être reliée à la ligne L1 à protéger.

Enfin, une troisième métallisation C est solidaire de la métallisation 21 formant barrière de Schottky avec le caisson 20. Cette métallisation C permet de prendre un contact destiné à relier les anodes des diodes de Schottky d1-d8 à la masse.

La face arrière du substrat est également métallisée (métallisation M). Cette dernière métallisation, reliée à la masse, est normalement montée sur l'embase métallique d'un boîtier. La métallisation C, qui doit également être reliée à la masse peut être reliée par fil à cette embase et/ou peut, comme cela est représenté, se prolonger vers une région superficielle surdopée 30 du substrat 1 et le contact vers la masse se réalise par l'intermédiaire des couches de même type de dopage 30, 1 et 2 vers la métallisation M.

Divers perfectionnements apparaissent en figure 3A. Notamment, des régions de type P plus fortement dopées sont disposées entre chacune des régions de type N formées à partir de la surface supérieure, à savoir une première région d'arrêt de canal 31 entre la région 3 et le caisson 10 et une deuxième région d'arrêt de canal 32 entre les caissons 10 et 20. En outre, de préférence, un anneau de garde de type P 13, 23 entoure les zones où les métallisations à barrière de Schottky 11 et 21 sont en contact avec les caissons. De façon classique, les diverses métallisations reposent sur des zones d'oxyde ayant préalablement servi de masque aux emplacements où elles ne sont pas en contact avec des zones spécifiques de la façon indiquée précédemment.

La figure 3B représente un exemple de vue de dessus d'un circuit selon la présente invention. De mêmes régions qu'en figure 3A sont désignées par les mêmes références numériques. Par souci de simplification, les zones d'anneau de garde et d'arrêt de canal n'ont pas été représentées. On retrouve dans cette figure 3B la métallisation A reliant chacune des cathodes des diodes d'1 (régions 12) à la cathode de la diode zener (région 3). Des métallisations B1 à B8, destinées à être connectées à des lignes L1 à L8, relient les régions 22 aux métallisations 11. On notera également qu'un caisson 10 unique peut être utilisé pour toutes les diodes d'1 à d'8 alors que chacune des diodes d1 à d8 est réalisée dans un caisson séparé.

Le circuit de la figure 3B sera de préférence disposé dans un boîtier muni de bornes dont chacune est reliée, par exemple par un fil d'or, à chacune des métallisations B1 à B8. De façon classique, avant soudure des fils, le composant aura été recouvert d'une couche de passivation (nitrure de silicium ou polyimide) et des ouvertures seront formées dans cette couche au-dessus des métallisatons B1 à B8 aux endroits où l'on souhaite établir les contacts. On pourra prévoir deux ouvertures par métallisation pour liaison à une borne d'arrivée de ligne et une borne de départ de ligne.

Bien entendu, la présente invention est susceptible de diverses variantes et perfectionnements qui apparaîtront à l'homme de l'art, qui saura notamment réaliser des barrières de Schottky selon diverses techniques connues.

En outre, un ensemble de protection dont toutes les polarités seraient inversées pourrait être réalisé en inversant tous les types de conductivité des couches de la structure décrite.

## Revendications

1. Circuit intégré constituant un réseau de diodes comportant des premières diodes Schottky (d1-d8) dont chacune est connectée par sa cathode à un point à protéger (L1-L8) et par son anode à une tension de référence et des deuxièmes diodes Schottky (d'1-d'8) dont chacune est connectée par son anode à un point à protéger et par sa cathode à la cathode d'une diode à avalanche (Z) dont l'anode est à la tension de référence, le circuit intégré comprenant:
un substrat (1) du premier type de conductivité (P) faiblement dopé dont la face inférieure est fortement dopée ;
un premier (10) et un deuxième (20) groupes de caissons du deuxième type de conductivité (N) faiblement dopés formés dans la face supérieure du substrat ;
un contact ohmique (12, 22) et un contact Schottky (11, 21) sur chaque caisson ;
une région (3) du deuxième type de conductivité (N) fortement dopée sur la surface supérieure du substrat ;
une première métallisation (A) reliant les contacts ohmiques du premier groupe de caissons à la région du deuxième type de conductivité (N) fortement dopée ;
une deuxième métallisation (C) reliant les contacts Schottky du deuxième groupe de caissons ;
des troisièmes métallisations (B1-B8) reliant respectivement un contact Schottky du deuxième groupe de caissons à un contact ohmique du premier groupe de caissons ; et
une quatrième métallisation (M) de face arrière.

2. Circuit intégré selon la revendication 1, caractérisé en ce que, en utilisation, la faoe arrière et la deuxième métallisation sont reliées à un potentiel de référence, et chacune des troisièmes métallisations est reliée à une ligne à protéger.

3. Circuit intégré selon la revendication 1, caractérisé en ce que les premiers caissons forment un seul et même caisson.

4. Circuit intégré selon la revendication 1, caractérisé en ce que chacun des deuxièmes caissons est séparé de ses voisins et des premiers caissons par une région d'arrêt de canal.

5. Circuit intégré selon la revendication 1, caractérisé en ce que chacun des contacts Schottky est cerné par un anneau de garde.

6. Circuit intégré selon la revendication 1, caractérisé en ce que la liaison entre la deuxième métallisation et le potentiel de référence est réalisée par un contact entre cette deuxième métallisation et une région surdopée de la face supérieure du substrat.

## Patentansprüche

1. Integrierte Schaltung, welche ein Diodennetz bildet, mit ersten Schottky-Dioden (dl-d8), von denen jede über ihre Kathode mit einem zu schützenden Punkt (L1-L8) und über ihre Anode mit einer Bezugsspannung verbunden ist, und zweiten Schottky-Dioden (d'1-d'8), von denen jede über ihre Anode mit einem zu schützenden Punkt und über ihre Kathode mit der Kathode einer Lawinendiode (Z) verbunden ist, deren Anode auf der Bezugsspannung liegt, mit folgenden Merkmalen:
einem schwach dotierten Substrat (1) des ersten Leitfähigkeitstyps (P), dessen Unterseite stark dotiert ist;
einer ersten (10) und einer zweiten (20) Gruppe von schwach dotierten Mulden des zweiten Leitfähigkeitstyps (N), welche auf der Oberseite des Substrats ausgebildet sind;
einem ohm'schen Kontakt (12, 22) und einem Schottky-Kontakt (11, 21) auf jeder Mulde;
einem stark dotierten Bereich (3) des zweiten Leitfähigkeitstyps (N) auf der Oberseite des Substrats;
einer ersten Metallisierung (A), welche die ohm'schen Kontakte der ersten Muldengruppe mit dem stark dotierten Bereich des zweiten Leitfähigkeitstyps (N) verbindet;
einer zweiten Metallisierung (C), welche die Schottky-Kontakte der zweiten Muldengruppe verbindet;
dritten Metallisierungen (B1-B8), welche jeweils einen Schottky-Kontakt der zweiten Muldengruppe mit einem ohm'-schen Kontakt der ersten Muldengruppe verbindet; und
einer vierten Metallisierung (M) auf der Rückseite.

2. Integrierte Schaltung nach Anspruch 1, dadurch **gekennzeichnet**, daß im Betrieb die Rückseite und die zweite Metallisierung mit einem Bezugspotential verbunden sind und alle dritten Metallisierungen mit einer zu schützenden Leitung verbunden sind.

3. Integrierte Schaltung nach Anspruch 1, dadurch **gekennzeichnet**, daß die ersten Mulden eine einzige Mulde bilden.

4. Integrierte Schaltung nach Anspruch 1, dadurch **gekennzeichnet**, daß alle zweiten Mulden von ihren Nachbarmulden und den ersten Mulden durch einen Kanalsperrbereich getrennt sind.

5. Integrierte Schaltung nach Anspruch 1, dadurch **gekennzeichnet**, daß jeder Schottky-Kontakt von einem Schutzring umgeben ist.

6. Integrierte Schaltung nach Anspruch 1, dadurch **gekennzeichnet**, daß die Verbindung zwischen der zweiten Metallisierung und der Bezugsspannung durch einen Kontakt zwischen dieser zweiten Metallisierung und einem überdotierten Bereich der Oberseite des Substrats realisiert ist.

## Claims

1. An integrated circuit constituting an array of diodes including first Schottky diodes (d1-d8), each of which is connected by its cathode to a point to be protected (L1-L8), and by its anode to a reference voltage, and second Schottky diodes (d'1-d'8), each of which is connected by its anode to a point to be protected and by its cathode to the cathode of an avalanche diode (Z), the anode of which is at the reference voltage; said integrated circuit comprising:
a low doped substrate (1) of a first conductivity type (P), the lower surface of which is highly doped;
first (10) and second (20) groups of low doped wells of the second conductivity type (N) formed in the upper surface of said substrate;
an ohmic contact (12, 22) and a Schottky contact (11, 21) on each well;
a highly doped region (3) of the second conductivity type (P) on the upper surface of said substrate;
a first metallization (A) connecting said ohmic contacts of the first group of wells to said highly doped region of the second conductivity type (P);
a second metallization (C) connecting said Schottky contacts of the second group of wells;
third metallizations (B1-B8) respectively connecting a Schottky contact of the second group of wells to an ohmic contact of said first group of wells; and
a fourth rear surface metallization (M).

2. An integrated circuit according to claim 1, characterized in that, in use, said rear surface and said second metallization are connected to a reference voltage, each third metallization being connected to a line to be protected.

3. An integrated circuit according to claim 1, characterized in that said first wells form one single well.

4. An integrated circuit according to claim 1, characterized in that each of said second wells is separated from the adjacent wells and from said first wells by a stop-channel region.

5. An integrated circuit according to claim 1, characterized in that each of said Schottky contacts is surrounded by a guard ring.

6. An integrated circuit according to claim 1, characterized in that the connection between said second metallization and said reference voltage is achieved by a contact between said second metallization and an overdoped region of the substrate upper surface.
